# EUROPEAN PATENT APPLICATION

(11) **EP 0 584 028 A1**
(43) Date of publication of application: **23.02.1994**
(21) Application number: 93480097.0
(22) Date of filing: 16.07.1993
(51) Int. Cl.: C23C 14/14, C23C 14/35

(54) **As-deposited large grain aluminium**

(30) Priority: 18.08.1992 US 931805
(71) Applicant: International Business Machines Corporation, Armonk, N.Y. 10504 (US)
(72) Inventor: Hagerstrom, David Joseph, Pleasant Valley, NY 12569 (US); Konecni, Anthony Joseph, Walden, NY 12586 (US); Srivastava, Kamalesh Kumar, Wappinger Falls, NY 12590 (US); Ingersoll, Catherine Davis, Wappingers Falls, NY 12590 (US); Lee, Pei-Ing, Williston, Vermont 05495 (US)
(74) Representative: Klein, Daniel Jacques Henri

(57) **Abstract**

A metal film, particularly of aluminum or an aluminum alloy, is deposited with a large grain structure at temperatures in the range of 50° C to 250° C by sputtering from a target having a large grain structure in which the average grain size is approximately equal to or greater than 1.0 mm and, preferably with a preferred crystal orientation within the grain structure. The sputtering process preferably includes sputtering across an increased area of the sputtering target by means of directing plasma to the sputtering target with a rotating magnetic field. An exemplary form of the sputtering arrangement having a rotating magnet is shown in the attached Figure. The sputtering chamber (110) is closed by a sputtering target (120) enclosing a wafer (130). A support (160) is provided to support a motor (140) and a magnet (150), driven thereby in close proximity to a sputtering target (160). The magnet (150) is preferably in the form of a specially distorted toroid. The approximate shape shown is preferred since the magnetic field produced thereby is evenly swept radially over the target with angular rotation. The formation of an as-deposited large grain film at a reduced temperature avoids the need for high temperatures during deposition and/or heat treatment such as annealing after the deposition of the metal film.

## Description

The present invention generally relates to the formation of metal films and, more particularly, to the formation of aluminum films which are resistant to migration effects.

The formation of films of varying thicknesses and of different materials forms a major portion of the manufacturing process for semiconductor devices and other articles. Therefore many techniques have been developed for this purpose. These techniques have also been refined for some materials such that the mechanical and electrical properties of the films can be closely controlled. Exam ples of such materials which can be deposited by variations in parameters and techniques of deposition processes are epitaxial silicon, polycrystalline silicon and amorphous silicon which may be selectively developed by performing the silicon deposition process at different temperatures.

In integrated circuits and electronic circuit modules, such as multi-layer modules formed of layers of glass, ceramic and or polymer, it is usually necessary to provide some metal films which are patterned to form connections between circuit elements therein. A number of particular metals are desirable for various applications and respective portions of the design. Among these, aluminum is often considered to be desirable due to its low cost and excellent electrical conduction properties. However, one characteristic of deposited aluminum films is the tendency to exhibit migration. When connections are made with aluminum films, particularly when the patterns are formed to design rules which allow a very small feature size, aluminum can migrate sufficiently to significantly reduce conductor cross-sectional area in some locations and cause corresponding increases of conductor dimensions in others. This reduction increases electrical resistance and may cause opens or shorts in the electronic device during manufacture or after the device is placed in service.

Several principal mechanisms are involved in migration of aluminum. Electromigration is basically electron current induced atomic migration. Stress migration is basically an aluminum void phenomenon induced by thermal and mechanical stresses in the aluminum film, as well as insulator passivation. Aluminum also tends to form clumps or "hillocks" where aluminum becomes concentrated and voids when the aluminum migrates away from a location toward a hillock.

The tendency of aluminum to migrate in this way has, in some cases, been significantly reduced by doping or alloying the aluminum with copper. However, the deposition of copper in small amounts simultaneously with aluminum imposes limitations and complications on the deposition process. For example, one problem which can result from copper doping is copper precipitation. This precipitation may result from either the amount of copper in the film or the temperature of the deposition process.

Precipitation of copper or other dopant material may occur between grains or at the interface of the alloy and its substrate. Such precipitation may complicate other integrated circuit manufacturing processes. For example, residuals will remain after reactive ion etching because of the low volatility of copper halides.

More recently, it has been found that the tendency of aluminum to migrate is largely a grain boundary diffusion phenomenon and closely correlated to grain size of the deposited aluminum, the number of triple points (e.g. the coincidence of boundaries of at least three grains) and the amount of joule heating. Some studies have reported modification of deposited crystallographic grain structure by angular distribution of the sources of sputtered material. Otherwise, large grain structure of aluminum has been obtained by the use of a relatively high temperature (e.g. 350°C or higher) during aluminum deposition or annealing at 350°C or a higher temperature after deposition. At such a temperature, however, thermal diffusion may adversely affect the as-deposited aluminum film.

Such a high temperature treatment to obtain increased grain size in deposited aluminum is often impossible or at least somewhat incompatible with present-day integrated circuit fabrication. High temperatures during deposition or annealing of the conductors is not tolerable since high temperatures and or heat treatment can easily cause dopant precipitation, oxidation, surface roughness, undesired alloy formation and other metallurgical problems. In turn, these problems impact product yield. The basic reason for this is that conductor patterns are most often formed after the formation of the transistors and other elements of the integrated circuit. The high temperatures involved tend to cause further diffusion of impurities within the semiconductor materials forming such transistors and other elements although diffusion of the impurities would be limited at 350°C.

Perhaps more importantly, the grain boundaries of the aluminum alloy, which are increased in small grain films, effectively form sites at which strain hardening of the metal can occur, effecting long term product reliability. Also, metal is typically deposited predominantly on an insulating layer which is susceptible to thermal damage such as cracking which could cause shorting of the conductors to undesired portions of the circuit or opens in the conductors themselves.

Substantial effort has, accordingly, been expended in attempting to discover a solution to the problem of aluminum migration and the formation of aluminum conductors at reduced temperatures. Among these approaches are alloying or doping the aluminum with silicon, tungsten and palladium. Also, some approaches have involved layering the aluminum with titanium, hafnium or tungsten. However, all of these approaches have increased the number and difficulty of process steps and also difficulties in patterning the deposited metal, such as in reactive ion etching (RIE) due to the relative difficulty of removal of the alloying metals. Perhaps more importantly, such approaches have caused an increase in sheet resistivity of the resulting conductive film which is extremely critical in most applications.

Further, manufacturers of sputter targets (e.g. bodies of material which provide the metal or metals to be deposited) have studied the effects of grain orientation and size on the uniformity of deposited metal films and the rate of deposition. It should be noted that since the sputter targets merely supply the material to be deposited, no limits are imposed on the treatments to which the sputter targets are subjected. Control of the crystallographic texture of such sputter targets both as to grain size and orientation by regulation of temperature and pressure (e.g so-called equal enthalpy processes) during formation of the sputtering targets are well-known in the art. Simulation has shown that a 5% - 10% improvement in deposition rate of the sputtered film with some increase in uniformity can be obtained if the sputter target has a high concentration of <100> crystallographic orientation of grain texture. However, variation in grain size over the range of 0.5 mm to 3.3 mm has been found to have no significant effect on the uniformity of the deposited film and little effect on deposition rate.

It is therefore an object of the present invention to provide large grain crystallographic structure in an asdeposited film formed at low temperature.

It is another object of the invention to provide a technique of low temperature deposition of aluminum or an aluminum alloy having a large grain structure.

It is a further object of the invention to provide a technique of forming a deposit of aluminum or an aluminum alloy which is resistant to migration without thermal treatment.

In order to accomplish these and other objects of the invention, a sputtering target is provided having a grain structure with an average grain size approximately equal to or greater than 1.0 mm and wherein the crystal orientation of said grain structure is predominately at least one of <100>, <111>, <110> and <311>.

In accordance with another aspect of the invention, a metal film having a large grain structure is formed by a process including the step of sputtering metal from a target having a grain structure with an average grain size equal to or greater than 1.0 mm.

In accordance with a further aspect of the invention, a method of depositing metal having a large grain structure is provided including the steps of sputtering metal from a sputtering target having a grain structure in which the average grain size is equal to or greater than 2.0 mm and depositing metal from the sputtering target on a surface.

The foregoing and other objects, aspects and advantages will be better understood from the following detailed description of a preferred embodiment of the invention with reference to the drawings, in which:
Figure 1 is an isometric representation of the facecentered cubic crystal structure of aluminum,
Figure 2 is an isometric depiction of crystal lattice orientations in each of a plurality of grains of a sputtering target in accordance with the invention,
Figure 3 shows an apparatus for carrying out the sputtering process in accordance with the invention, and
Figure 4 shows an view of the rotating magnet of Figure 3 in a direction parallel to the axis of rotation..

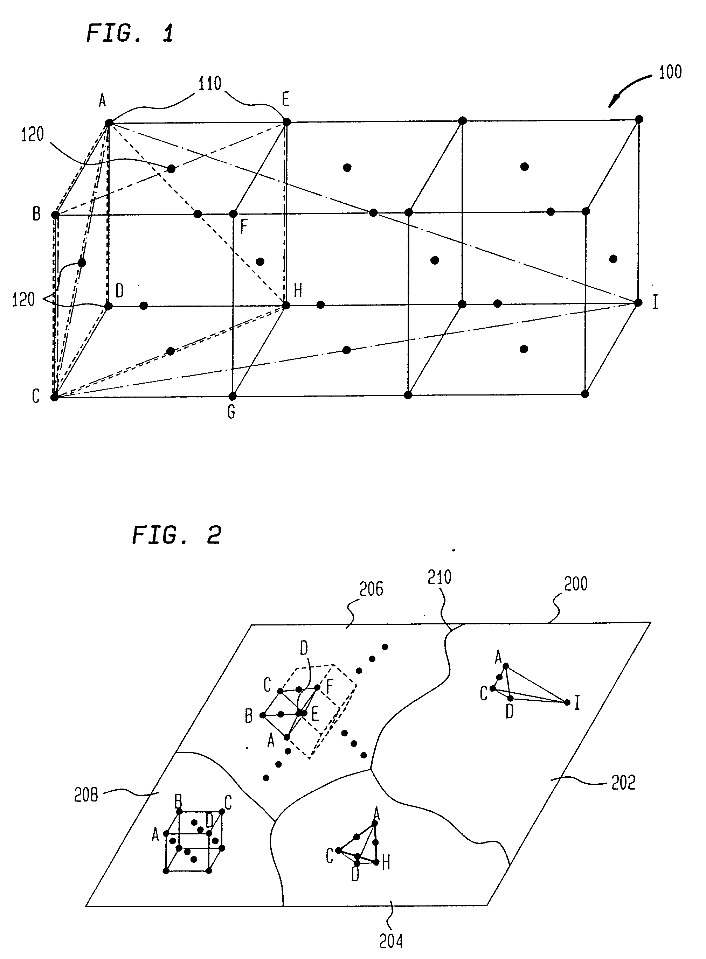

Referring now to the drawings, and more particularly to Figure 1, there is shown an isometric representation of the crystal structure typical of aluminum. The basic crystal lattice 100 is a repeating structure that can be visualized as having atoms 100 located at each corner of a cube and other atoms 120 centered in each face of each cube. Accordingly, this lattice structure is referred to as face-centered cubic (FCC) and is typical not only of aluminum but a number of other metals such as copper, lead and silver. As is well-understood, the crystal structure will be uniform throughout a grain of the metal but the relative orientations of the crystal lattice will differ from grain to grain.

The orientation of the crystal structure in a grain is often described in terms of Miller indices which is an expression of a direction in integral multiples of atomic diameters in each of the three coordinate directions. For cubic lattice structures, the Miller indices of a direction will be the same as for a plane perpendicular to that direction. Further, in cubic lattices, many of these directions will be equivalent and equivalent directions are denoted by angle brackets.

The inventors have discovered that a deposited aluminum film having a grain size comparable to that obtained at 350°C can be obtained at much reduced temperatures (e.g. below 150° C or within a range of roughly 50°C to 250°C) with good uniformity of doping by using a sputtering target having both large grain and preferred crystallographic orientation of the grain. Specifically, average grain size of approximately 1 mm or greater and preferred grain crystallographic orientation of <100>, <111>, <110> and <311> will produce a deposited film with a grain size of about 10 times the grain size which would otherwise be obtained at the same deposition temperature. Each of these crystal orientations is preferably approximately equally distributed in number but with the <100> and <111> orientations preferably slightly greater than the <110> and <311> orientations. Either aluminum or an alloy of aluminum containing approximately 0.5% to 40% by weight copper may be used with somewhat enhanced results being obtained for the alloy. Similar results are expected for other alloys with metals having a similar FCC characteristic lattice structure.

These crystallographic grain orientations may be visualized from Figure 1 by considering a theoretical planar surface of the sputtering target coinciding with one of four planes indicated. Specifically, for the <100> orientation, the crystal lattice would be oriented such that the plane of the surface of the sputter target would be parallel to rectangle ABCD (indicated by short dashed lines) or its equivalent. For the <111> orientation, the crystal structure of the grain would be such that the plane would be parallel to triangle ACH (indicated by long dashed lines) or its equivalent (e.g. EGD, FCH, etc.). Similarly, the <110> and <311> orientations would correspond to rectangle BEHC (indicated by two-dot chain lines) and triangle ACI (indicated by single-dash chain lines), respectively, and their respective equivalents.

These crystal orientations may be further visualized by reference to Figure 2 in which the theoretical plane referred to above is represented by plane 200. This plane is shown divided by lines 210 into four separate grains 202, 204, 206 and 208. Within each grain, the FCC crystal structure is uniform and corresponds to repetition of the crystal structure orientations illustrated. For example, in grain 206, rectangle BCEF is parallel to theoretical plane 200. The remainder of the cube (e.g. locations A and D are also shown and the remainder of the crystal lattice would appear as a repetition thereof as partially shown in dashed lines. Thus, it is seen that Figure 2 represents an idealized form of the sputtering target in accordance with the invention.

The process of metal deposition is preferably carried out by sputtering which, itself, is well understood in the art. Preferred conditions are below 150°C and pressure between 0,2 and 0,7 Pa. (1.5 and 5.0 mTorr). The temperature of the sputtering process is dependent on the metal or alloy to be sputtered and generally is conducted in the range from 50° to 250° C. However, as indicated above, the method of the invention differs from known sputtering processes by the provision of a sputtering target which is formed to have both large grains and a preferred orientation of the crystallographic structure within each grain. It should be noted in this regard that grain structure of the sputtering target can be altered by annealing and other processes and these effects on the sputtering target can be effectively transferred to an integrated circuit structure by virtue of the invention without heat treatment of the integrated circuit, itself.

Additionally, it is preferable to utilize a recent development of the sputtering process in which ions or a plasma are directed against a surface of the sputtering target with a rotating magnetic field in the vicinity of the sputtering target. By doing so, the ions of the plasma are more evenly distributed over a surface of the sputtering target and the metal or metal alloy is more evenly sputtered from the surface of the target. While this technique was developed and has been used by others to enhance metal deposition rate, it has been discovered by the inventors that the application of the technique to a large grain sputtering target yields a substantial increase of about a factor of ten in as-deposited grain size even when there is no preferential crystal orientation within the grain structure of the sputtering target. However, a generally equal distribution of the preferred grain crystal orientations yields an even larger grain size in the deposited metal film, leading to a theory of the invention that the sputter etched species from the target will deposit preferentially at sites bearing some relationship to the point in the crystal lattice from which they were sputter etched. Thus, the sputtering from an area of the sputtering target which will maintain a roughly uniform population of sputtered species will preferentially be deposited, regardless of temperature, at locations including species from related lattice positions, resulting in an as-deposited large grain film. The combination of sputtering from a large area of a sputtering target and a sputtering target having large grain and preferred grain orientations will enhance the preferential deposition process by limiting the number of sputtered species while maintaining a generally uniform population of those species. Therefore, statistically, sputtering from a larger area of the sputtering target having large grain will result in an increased uniformity of the population of metal species in the plasma which will be preferentially deposited as large grains. This effect can be further enhanced by preferential crystal orientation within the grain structure of the sputtering target.

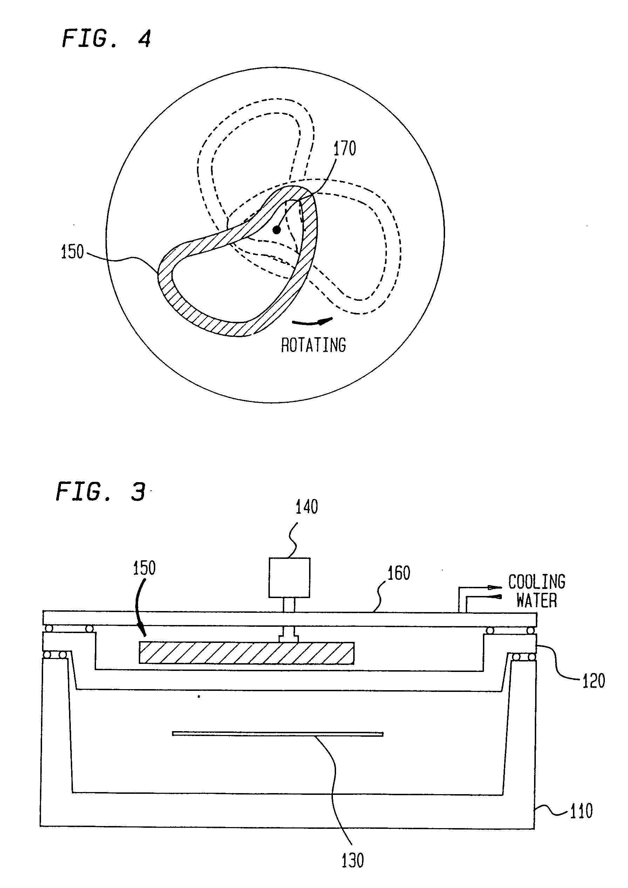

An exemplary form of the sputtering arrangement having a rotating magnet is shown in Figures 3 and 4. In Figure 3, the sputtering chamber 110 is closed by a sputtering target 120, enclosing wafer 130. A support 160 is provided to support a motor 140 and a magnet 150, driven thereby in close proximity to sputtering target 160. As shown in the view of Figure 4, along the axis 170 of magnet rotation, the magnet 150 is preferably in the form of a specially distorted toroid. The approximate shape shown is preferred since the magnetic field produced thereby is evenly swept radially over the target with angular rotation. However, it is to be understood that other arrangements for achieving an evenly distributed sputter etching could also be employed.

In view of the foregoing, it is evident that the present invention provides a method and means for depositing large grain aluminum or aluminum alloy at a low temperature and which is thereafter highly resistant to electromigration, stress migration and hillock formation and which improves product reliability. Also the product manufacturing yield will be increased through the prevention of dopant precipitation, surface roughness or undesirable alloy formation. While the mechanism by which such large grain formation is favored is not considered to be fully understood, the deposition process has been experimentally verified by sputtering from four sputter targets to form metal films on approximately seven thousand wafers with high uniformity and large grain structures comparable to prior films deposited or annealed at 350°C. Thus, the invention allows the avoidance of heat treatment or high temperature processing and does not involve alloying with materials which restrict or complicate other processes and effectively transfers important qualities of grain structure of a sputtering target to an integrated circuit product, as described above. It should also be understood that the process and apparatus in accordance with the invention, while particularly applicable to solving a metallurgical problem peculiar to aluminum, is also applicable to other metals and alloys, particularly metals exhibiting a face-centered cubic crystal structure.

## Claims

1. A sputtering target having a grain structure with an average grain size approximately equal to or greater than 1.0 mm and wherein the crystal orientation of said grain structure is predominately at least one of <100>, <111>, <110> and <311>.

2. A sputtering target as recited in claim 1, wherein the number of grains of said grain structure has at least one of said <100> and <111> crystal orientations which exceeds the number of grains of said grain structure having at least one of said <110> and <311> crystal orientations.

3. A sputtering target as recited in claim 1, wherein the number of grains of said grain structure has at least one of said <100> and <111> crystal orientations which exceeds the number of grains of said grain structure having said <110> and <311> crystal orientations.

4. A sputtering target as recited in claim 1, wherein the number of grains of said grain structure has said <100> and <111> crystal orientations which exceeds the number of grains of said grain structure having said <110> and <311> crystal orientations.

5. A sputtering target as recited in claim 1, wherein said sputtering target consists essentially of a material selected in the group comprising: aluminum and aluminum alloys.

6. A sputtering target as recited in claim 6, wherein said sputtering target consists essentially of an alloy of aluminum and copper.

7. A sputtering target as recited in claim 6, wherein said sputtering target contains an amount of copper in the range of 0.5% - 40% by weight.

8. A metal film having a large grain structure formed by a process including the steps of
sputtering metal from a target having a grain structure with an average grain size equal to or greater than 1.0 mm, and
depositing said metal sputtered from said target in said sputtering step onto a surface.

9. A metal film as recited in claim 8, wherein said grain structure sputtering target has a crystal orientation of said grain structure which is predominately at least one of <100>, <111>, <110> and <311>.

10. A metal film as recited in claim 9, wherein the number of grains of said grain structure of said sputtering target has at least one of said <100> and <111> crystal orientations which exceeds the number of grains of said grain structure having at least one of said <110> and <311> crystal orientations.

11. A metal film as recited in claim 9, wherein the number of grains of said grain structure sputtering target has at least one of said <100> and <111> crystal orientations exceeds the number of grains of said grain structure having said <110> and <311> crystal orientations.

12. A metal film as recited in claim 9, wherein the number of grains of said grain structure sputtering target has said <100> and <111> crystal orientations exceeds the number of grains of said grain structure having said <110> and <311> crystal orientations.

13. A method of depositing metal having a large grain structure including the steps of:
sputtering metal from a sputtering target having a grain structure in which the average grain size is equal to or greater than 2.0 mm and
depositing metal from said sputtering target on a surface.

14. A method as recited in claim 13, wherein said grain structure sputtering target has a crystal orientation of said grain structure which is predominately at least one of <100>, <111>, <110> and <311>.

15. A method as recited in claim 14, wherein the number of grains of said grain structure has at least one of said <100> and <111> crystal orientations which exceeds the number of grains of said grain structure having at least one of said <110> and <311> crystal orientations.

16. A method as recited in claim 14, wherein the number of grains of said grain structure has at least one of said <100> and <111> crystal orientations which exceeds the number of grains of said grain structure having said <110> and <311> crystal orientations.

17. A method as recited in claim 14, wherein the number of grains of said grain structure has said <100> and <111> crystal orientations which exceeds the number of grains of said grain structure having said <110> and <311> crystal orientations.

18. A method as recited in claim 13, including the further steps of
generating a plasma and
directing said plasma substantially evenly over time across a surface of said sputtering target.

19. A method as recited in claim 21, wherein said step of directing said plasma includes the further step of
producing a rotating magnetic field in the vicinity of said sputtering target.
